# EUROPÄISCHE PATENTSCHRIFT

(11) **EP 0 453 508 B1**
(45) Veröffentlichungstag und Bekanntmachung des Hinweises auf die Patenterteilung: **10.03.1993**
(21) Anmeldenummer: 90902783.1
(22) Anmeldetag: 11.01.1990
(51) Int. Cl.: H03L 1/02, H03K 17/95

(54) **TEMPERATURSTABILER SCHWINGKREISOSZILLATOR**
OSCILLATOR STABILIZED AGAINST VARIATIONS IN TEMPERATURE FOR OSCILLATING CIRCUITS
OSCILLATEUR STABLE EN TEMPERATURE POUR CIRCUITS OSCILLANTS

(30) Priorität: 13.01.1989 DE 3900802
(43) Veröffentlichungstag der Anmeldung: 30.10.1991
(73) Patentinhaber: Festo KG, D-73734 Esslingen (DE)
(72) Erfinder: KRIZ, Dieter, D-5880 Lüdenscheid (DE)
(74) Vertreter: Abel, Martin, Dipl.-Ing.
(86) Internationale Anmeldenummer: EP9000058
(87) Internationale Veröffentlichungsnummer: WO9008429

(56) Entgegenhaltungen:
- EP-A- 0 070 796
- DE-A- 3 513 403
- US-A- 4 270 102
- Patent Abstracts of Japan, Band 12, Nr. 481 (E-694)(3328), 15 Dezember 1988 & JP,A,63198414 (YAMATAKE HONEYWELL) 17 August 1988

## Beschreibung

Die Erfindung bezieht sich auf einen transistorisierten Schwingkreisoszillator, insbesondere in einem Näherungsschalter, mit einer im Stromkreis des Schwingkreistransistors angeordneten, von einem Temperaturfühler gesteuerten Stromquelle, der bei ansteigender Temperatur die Stromquelle aufsteuert und umgekehrt, um die Schwingkreisspannung zu stabilisieren.

Es ist bekannt, daß das Schwingungsverhalten von Schwingkreisoszillatoren abhängig ist von der Umgebungstemperatur. Bei induktiven Näherungsschaltern, die einen Schwingkreisoszillator aufweisen, wird eine hohe Empfindlichkeit verlangt, weil anders der Schalter auf geringfügige Abstandsänderungen des zu erfassenden Zieles nicht genau genug reagiert. Wegen der Temperaturabhängigkeit der Schwingkreisspule ändert sich der Resonanzwiderstand des Schwingkreises mit der Folge, daß die Schaltpunkte des Näherungsschalters nicht temperaturstabil sind. Man hat versucht, diese Temperaturabhängigkeit mittels eines im Rückkopplungszweig des Schwingkreistransistors angeordneten temperaturabhängigen Widerstandes (NTC-Widerstand) zu kompensieren. Eine solche Temperaturkompensation hat mehrere Nachteile:
a) Die Kompensation mittels des temperaturabhängigen Widerstandes ist nicht optimal, weil die temperaturabhängige Widerstandskennlinie der Schwingkreisspule linear ist, der Widerstandskennlinie des temperaturabhängigen Widerstandes aber eine e-Funktion folgt.
b) Die Anfangstoleranzen des temperaturabhängigen Widerstandes sind mit +/- 20 % recht groß und seine Langzeitstabilität ist relativ schlecht.
c) Der temperaturabhängige Widerstand befindet sich im HF-durchflossenen Rückkopplungszweig und muß deshalb in unmittelbarer Nähe des Schwingkreisoszillators angeordnet sein. Eine thermische Kopplung mit der Spule, die die Voraussetzung für eine gute Temperaturkompensation ist, würde deshalb zu für HF zu langen Verbindungsleitungen des Widerstandes führen.
d) Der in der Regel übliche Abgleichswiderstand zur Einstellung des Schaltabstandes, der in Reihe mit dem temperaturabhängigen Widerstand liegt, beeinflußt die Kompensationswirkung des temperaturabhängigen Widerstandes.
e) Da der Abgleichswiderstand HF-durchflossen ist, muß er ebenfalls in der Nähe des Schwingkreisoszillators angeordnet sein. Deshalb kann er nicht mit langen Verbindungsleitungen an das hintere Ende des als Hybridschaltung ausgebildeten Schwingkreisoszillators angeordnet werden, was für einen einfachen Laserabgleich günstig wäre.

Bei einem bekannten transistorisierten Schwingkreisoszillator ist die Stromquelle Teil eines transistorisierten Stromspiegelkreises, der von einem von der Umgebungstemperatur abhängigen, als Thermistor ausgebildeten Fühler angesteuert wird (Patent Abstract of Japan, Bd. 12, Nr. 481 (E-694) (3328), 15.12.1988).

Mit einem solchen, Teil eines Näherungsschalters bildenden Schwingkreisoszillators läßt sich keine 100%-ige Temperaturkompensation des temperaturabhängigen Schwingkreises erzielen, weil bei einer solchen Schaltung der Temperaturgang des temperaturempfindlichen Bauteiles des Schwingkreises, nämlich der Spule und des davon mit Abstand angeordneten Thermistors, unterschiedlich sein kann und weil die Kennlinien beider Bauelemente nicht nur unterschiedliche Steilheiten haben, sondern auch sonst unterschiedlich sind. Große, heutzutage geforderte Schaltabstände von 10 mm und mehr mit hoher Präzision lassen sich deshalb mit solchen Näherungsschaltern nicht erreichen.

Bei einer anderen bekannten Oszillatorschaltung wird als Fühler ein Teil der Wicklung der Schwingkreisspule verwendet. Auf diese Art und Weise ist zwar gewährleistet, daß die Temperatur unmittelbar an dem Bauteil erfaßt wird, was für die Temperaturabhängigkeit des Schwingungsverhaltens des Schwingkreises verantwortlich ist, doch hat die Praxis gezeigt, daß mit diesen Mitteln für die Praxis geeignete Schaltungen nicht zu verwirklichen sind (EP-A1-0 070 796).

Der Erfindung liegt die Aufgabe zugrunde, einen Schwingkreisoszillator zu schaffen, der hinsichtlich der Temperaturkompensation der Schwingkreisspule gegenüber herkömmlichen Schwingkreisoszillatoren verbessert ist.

Diese Aufgabe wird bei einem Schwingkreisoszillator der eingangs genannten Art dadurch gelöst, daß der Temperaturfühler ein mit der Schwingkreisspule thermisch gekoppelter Transistor ist, wobei durch ihn die Ansteuerung der Stromquelle über eine Steuereinrichtung erfolgt, die die linearen Steilheiten vom thermisch gekoppelten Transistor und von der Schwingkreisspule einander anpaßt. Dabei ist vorzugsweise der Transistor unmittelbar an der Schwingkreisspule angebracht. Da die Schwingkreisspule in der Regel einen Kern aufweist, ist der Transitor vorzugsweise an dem Kern angebracht, insbesondere aufgeklebt.

Bei der Erfindung liegt kein Element zur Temperaturkompensation in einem HF-durchflossenen Zweig. Deshalb läßt sich der als Fühler arbeitende und in einem Gleichstromzweig liegende Transistor ohne Nachteile für die Kompensation auch mit langen Verbindungsleitungen bis zur Spule verlegen. Auf diese Art und Weise ist gewährleistet, daß der Transistor und die Schwingkreisspule die gleiche Temperatur haben. Da ein Transistor eine lineare Kennlinie in engen Toleranzen und eine gute Langzeitstabilität hinsichtlich seiner Daten hat, ist eine optimale Temperaturkompensation der ebenfalls eine lineare Kennlinie aufweisenden Schwingkreisspule gewährleistet.

Eventuell unterschiedliche Steilheiten der linearen Kennlinien der Schwingkreisspule und des an ihr angebrachten Transistors lassen sich beispielsweise durch einen der Stromquelle vorgeschalteten Multiplizierer anpassen.

Nach einer vorteilhaften Ausgestaltung der Erfindung ist ein Widerstand für den Schaltabstandsabgleich des Oszillators der Steuerschaltung der Stromquelle zugeordnet. Da auch dieser Abgleichwiderstand genauso wie der Transistor nicht mehr HF-durchflossen, sondern von Gleichstrom durchflossen ist, kann er über längere Verbindungsleitungen an eine Stelle gelegt werden, wo er für den Abgleich besonders gut plaziert ist. Diese Steuerschaltung beinhaltet den Multiplizierer für die Anpassung der linearen Kennlinien. Die Anpassung läßt sich an dem Widerstand für den Schaltabstandsabgleich vornehmen.

Insgesamt ergibt sich aufgrund der Erfindung eine verbesserte Temperaturkompensation mit der Folge, daß ein induktiver Näherungsschalter, der den erfindungsgemäßen Schwingkreisoszillator umfaßt, eine verbesserte Schaltabstandsstabilität hat.

Im folgenden wird die Erfindung anhand eines einen Schwingkreisoszillator für einen induktiven Näherungsschalter darstellenden Schaltbildes näher erläutert.

An einer Gleichspannungsquelle U_{B} liegt eine Reihenschaltung aus einem Schwingkreis mit einer Schwingkreisspule L und Schwingkreiskondensatoren C1,C2, einem Schwingkreistransistor T1 und einer steuerbaren Stromquelle Q. Der in Basisschaltung betriebene Schwingkreistransistor T1 ist rückgekoppelt. Die Basis des Schwingkreistransistors T1 ist über einen Widerstand R an der Gleichspannungsquelle U_{B} angeschlossen. Der Schwingkreis L,C1,C2 und der rückgekoppelte Schwingkreistransistor T1 bilden den Oszillator.

In Reihe zur Kollektoremitterstrecke des Schwingkreistransistors T1 liegt eine steuerbare Stromquelle Q. Für die Steuerung der Stromquelle Q ist eine Steuereinrichtung S vorgesehen, die in Abhängigkeit von der Einstellung eines Abgleichwiderstandes R die Stromquelle Q steuert. Das Steuersignal für die Stromquelle Q ist weiter abhängig von dem Signal eines als Transistor T2 ausgebildeten Temperaturfühlers. Der Transistor T2 ist auf dem Kern der Schwingkreisspule L derart aufgeklebt, daß er die Temperaturänderungen der Schwingkreisspule L mitmacht. Zur Anpassung der in der Regel unterschiedlichen Steilheiten der von der Temperatur abhängigen Stromkennlinien der Schwingkreisspule L und des Transistors T2 dient die Steuereinrichtung S. Durch Einstellen des Abgleichswiderstandes R_{TK} kann die Steuerwirkung des Transistors T2 so eingestellt werden, daß eine absolute Temperaturkompensation erreicht wird.

Die Funktion des temperaturstabilen Schwingkreisoszillators ist folgende:
Der Oszillator ist so eingestellt, daß er bei Normaltemperatur ohne Bedämpfung durch ein metallisches Ziel schwingt. Bei schwingendem Oszillator kann am Ausgang die Oszillatorspannung abgenommen und durch die Auswerteschaltung für Schaltfunktionen ausgewertet werden. In Abhängigkeit von einem in die Nähe der Schwingkreisspule L gebrachten metallischen Zieles ändert sich die Güte des Schwingkreises L,C1,C2, so daß der Oszillator bei einem bestimmten Abstand des metallischen Zieles aufhört zu schwingen. Dieses Verhalten wäre temperaturabhängig, wäre nicht die spezielle Temperaturkompensation für die Schwingkreisspule L vorgesehen. Sinkt beispielsweise infolge einer Temperaturerhöhung der AC-Anteil des Schwingkreisstroms, dann wird dieser Verminderung des Schwingkreisstroms dadurch entgegengewirkt, daß über den Transistor T2 ein Signal an die Steuerschaltung S gegeben wird, die die Stromquelle Q weiter öffnet, so daß im Ergebnis bei einer Temperaturerhöhung durch eine von der Stromquelle Q aufgezwungene Änderung des die Spule L durchfließenden Stroms der Schaltabstand konstant bleibt. Die am Ausgang des Schwingkreises abgenommene Schwingkreisspannung bleibt damit auch konstant.

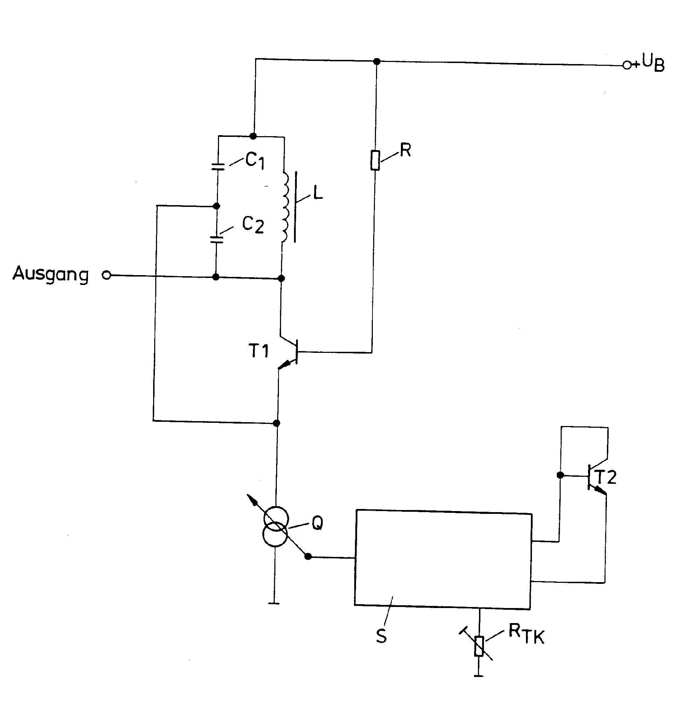

## Patentansprüche

1. Transistorisierter Schwingkreisoszillator, insbesondere in einem Näherungsschalter, mit einer im Stromkreis des Schwingkreistransistors (T1) angeordneten, von einem Temperaturfühler gesteuerten Stromquelle (Q), der bei ansteigender Temperatur die Stromquelle (Q) aufsteuert und umgekehrt, um die Schwingkreisspannung zu stabilisieren,
**dadurch gekennzeichnet,** daß der Temperaturfühler ein mit der Schwingkreisspule (L) thermisch gekoppelter Transistor (T1) ist, wobei durch ihn die Ansteuerung der Stromquelle (Q) über eine Steuereinrichtung (ST) erfolgt, die die linearen Steilheiten vom thermisch gekoppelten Transistor (T2) und von der Schwingkreisspule (L) einander anpaßt.

2. Schwingkreisoszillator nach Anspruch 1,
**dadurch gekennzeichnet,** daß der Transistor (T2) unmittelbar an der Schwingkreisspule (L) angebracht ist.

3. Schwingkreisoszillator nach Anspruch 2,
**dadurch gekennzeichnet,** daß bei einer einen Kern aufweisenden Schwingkreisspule (L) der Transistor (T2) am Kern angebracht ist.

4. Näherungsschalter mit einem Schwirgkreisoszillator nach einem der Ansprüche 1 bis 3,
**dadurch gekennzeichnet**, daß ein Widerstand (RTK) für den Schaltabstandsabgleich des Oszillators der Steuerschaltung (S) der Stromquelle (Q) zugeordnet ist.

## Claims

1. A transistorized resonant circuit oscillator, in particular in an proximity switch, with a power source (Q) incorporated in the circuit of the resonant circuit transistor (T1) and controlled by a temperature sensor which increases the power source current at rising temperatures and vice versa in order to stabilise the resonant circuit voltage, characterized in that the temperature sensor is a transistor (T2) thermally coupled to the resonant circuit coil (L), said transistor driving the power source (Q) via a control device (S) which matches the linear slopes of the thermally coupled transistor (T2) to those of the resonant circuit coil (L).

2. A resonant circuit oscillator according to Claim 1, characterized in that the transistor (T2) is directly mounted on the resonant circuit coil (L).

3. A resonant circuit oscillator according to Claim 2, characterized in that the transistor (T2) is mounted on the core of the resonant circuit coil (L), if a core is provided.

4. A proximity switch incorporating a resonant circuit oscillator according to any of Claims 1 to 3, characterized in that a resistor (RTK) for switching clearance compensation is allocated to the control circuit (S) of the power source (Q).

## Revendications

1. Oscillator transistorisé pour circuits oscillants, utilisable en particulier dans un détecteur de proximité, comprenant une source de courant (Q) disposée dans le circuit de courant du transistor (T1) du circuit oscillant et asservie par un capteur de température, lequel asservit la source de courant (Q) dans un sens croissant en cas de température croissante et vice-versa, pour stabiliser la tension du circuit oscillant, **caractérisé en ce que** le capteur de température est un transistor (T2) couplé thermiquement avec l'enroulement (L) du circuit oscillant, grâce auquel l'asservissement de la source de courant (Q) s'effectue par l'intermédiaire d'un dispositif de commande (S), lequel adapte les unes aux autres les pentes linéaires du transistor couplé thermiquement (T2) et de l'enroulement (L) du circuit oscillant.

2. Oscillateur pour circuits oscillants selon la revendication 1, caractérisé en ce que le transistor (T2) est monté directement sur l'enroulement (L) du circuit oscillant.

3. Oscillateur pour circuits oscillants selon la revendication 2, caractérisé en ce que, dans le cas d'un enroulement (L) du circuit oscillant comportant un noyau, le transistor (T2) est monté sur le noyau.

4. Détecteur de proximité pourvu d'un oscillateur pour circuits oscillants selon l'une des revendications 1 à 3, caractérisé en ce qu'une résistance (RTK) est associée au circuit de commande (S) de la source de courant (Q) pour l'ajustage de l'intervalle de commutation de l'oscillateur.
